# EUROPEAN PATENT APPLICATION

(11) **EP 4 712 140 A1**
(43) Date of publication of application: **18.03.2026**
(21) Application number: 25176012.0
(22) Date of filing: 13.05.2025
(51) Int. Cl.: H01L 25/065, H01L 23/498, H01L 21/60, H01L 21/98, H01L 23/31

(54) **SEMICONDUCTOR PACKAGE AND METHOD FOR MANUFACTURING THE SAME**

(30) Priority: 13.09.2024 KR 20240126136
(71) Applicant: Samsung Electronics Co., Ltd., Suwon-si, Gyeonggi-do 16677 (KR)
(72) Inventor: KIM, Ji Hwang, 16677 Suwon-si, Gyeonggi-do (KR); KIM, Dongwook, 16677 Suwon-si, Gyeonggi-do (KR); MUN, Kyung Don, 16677 Suwon-si, Gyeonggi-do (KR)
(74) Representative: Kuhnen & Wacker Patent- und Rechtsanwaltsbüro PartG mbB

(57) **Abstract**

A semiconductor package includes a first redistribution structure (120), a first chiplet (130) on the first redistribution structure (120), a second chiplet (140) on the first redistribution structure (120) and proximate the first chiplet (130) in a horizontal direction parallel to a surface of the first redistribution structure (120), a second redistribution structure (170) on the first chiplet (130) and on the second chiplet (140), and a communication chip on the second redistribution structure (170).

## Description

### BACKGROUND

The present disclosure relates generally to a semiconductor package and a method for manufacturing the same.

Semiconductor technology for manufacturing an application processor (AP) by dividing it into chiplets according to the usage or the process to which it is applied has been developed and used. When an application processor is manufactured by dividing it into chiplets, since it is possible to apply an inexpensive old process to a chiplet which does not require use of the latest process, it is possible to reduce the manufacturing cost, and when a defect occurs in a chiplet to which an old process has been applied, it is possible to discard only the chiplet to which the old process has been applied, such that it is possible to improve the yield of application processors. Further, when an application processor is manufactured by dividing it into chiplets and the individually manufactured chiplets are operated together, it is possible to overcome the performance limitation of the conventional single application processor.

When an application processor is divided into chiplets, there is a problem that the space inside a semiconductor package which is occupied by the application processor formed with chiplets becomes larger as compared to the case where a single application processor is adopted. For this reason, in the related art, a communication chip package is formed separately from a semiconductor package, and the semiconductor package including chiplets and the communication chip package are mounted together inside an electronic product.

However, with the recent development of mobile devices, the demand for electronic products with small sizes and large battery capacity is increasing. Accordingly, in order to reduce the board size in an electronic product and secure space where a large-capacity battery can occupy, it is required to reduce an area in the electronic product which is occupied by a communication chip package.

### SUMMARY

The present disclosure solves at least the above-identified problem by providing an application processor capable of being divided into a first chiplet and a second chiplet and mounted on the lower package of a package-on-package (PoP) device.

Also, the present disclosure attempts to provide a communication chip capable of being mounted on the upper package of the package-on-package (PoP) device. In this manner, aspects of the inventive concept eliminate the need to separately form a communication chip package, thereby increasing the amount of available free space within the electronic product.

A semiconductor package according to an embodiment may include a first redistribution structure, a first chiplet on the first redistribution structure, a second chiplet on the first redistribution structure and next to (i.e., proximate) the first chiplet, a second redistribution structure on the first chiplet and on the second chiplet, and a communication chip on the second redistribution structure.

A semiconductor package according to an embodiment may include a first redistribution structure, a plurality of chiplets on a first surface of the first redistribution structure, a plurality of connection members on the first surface of the first redistribution structure and around the plurality of chiplets, a second redistribution structure on the plurality of chiplets and on the plurality of connection members, a communication chip on the second redistribution structure, and a plurality of memory structures on the second redistribution structure and around the communication chip.

A semiconductor package according to an embodiment may include a front side redistribution structure, a first logic chiplet on the front side redistribution structure, a second logic chiplet on the front side redistribution structure and next to the first logic chiplet, a plurality of connection members on the front side redistribution structure and next to the first logic chiplet, a first molding material covering the first logic chiplet, the second logic chiplet, and the plurality of connection members on the front side redistribution structure, a back side redistribution structure on the first molding material, a memory structure on the back side redistribution structure, and a communication chip on the back side redistribution structure and next to the memory structure.

The communication chip may be mounted on the upper package of a package-on-package (PoP) device including an application processor divided into a first chiplet and a second chiplet. Accordingly, it is not necessary to separately form a communication chip package, and it is possible to reduce the space inside an electronic product that is conventionally occupied by a separate communication chip package.

The communication chip may be disposed directly on the first chiplet and the second chiplet. Accordingly, heat which is generated by the first chiplet and the second chiplet can be efficiently discharged to the outside (i.e., surrounding environment) via the communication chip.

### BRIEF DESCRIPTION OF THE DRAWINGS

The above and other aspects, features, and advantages of the present disclosure will be more clearly understood from the following detailed description, taken in conjunction with the accompanying drawings, wherein like reference numerals (when used) indicate corresponding elements throughout the several views, and in which:
FIG. 1 is a schematic cross-sectional view illustrating a semiconductor package of an embodiment of the present disclosure;
FIG. 2 is a schematic cross-sectional view illustrating a semiconductor package of an embodiment of the present disclosure;
FIG. 3 is a schematic cross-sectional view illustrating a semiconductor package of an embodiment of the present disclosure;
FIG. 4 is a schematic plan view illustrating the upper surface of each of the semiconductor packages of the embodiments of FIGS. 1, 2, and 3;
FIG. 5 is a schematic cross-sectional view illustrating a semiconductor package of an embodiment of the present disclosure;
FIG. 6 is a schematic plan view illustrating the upper surface of the semiconductor package of the embodiment of FIG. 5; and
FIGS. 7 to 16 are schematic cross-sectional views illustrating intermediate processes in an example method for manufacturing the semiconductor package of the embodiment of FIG. 1, according to one or more embodiments of the present disclosure.

### DETAILED DESCRIPTION

In the following detailed description, only certain embodiments of the present disclosure have been shown and described, simply by way of illustration. As those skilled in the art would realize, the described embodiments may be modified in various different ways, all without departing from the scope of the present disclosure.

The drawings and description are to be regarded as illustrative in nature and not restrictive. Like reference numerals designate like elements throughout the specification.

In addition, the size and thickness of each configuration shown in the drawings are arbitrarily shown for understanding and ease of description, but the present disclosure is not limited thereto.

Throughout this specification, when a part is referred to as being "connected" to another part, it may be directly connected to the other part, or may be connected to the other part indirectly with any other elements interposed therebetween. In addition, unless explicitly described to the contrary, the word "comprise", and variations such as "comprises" or "comprising", will be understood to imply the inclusion of stated elements but not the exclusion of any other elements.

Further, it will be understood that when an element such as a layer, film, region, or substrate is referred to as being "on" another element, it can be directly on the other element or intervening elements may also be present. In contrast, when an element is referred to as being "directly on" another element, there are no intervening elements present. Further, when an element is "above" or "on" a reference portion, the element is located above or below the reference portion, and it does not necessarily mean that the element is located "above" or "on" in a direction opposite to gravity.

Further, in the entire specification, when it is referred to as "on a plane", it means when a target part is viewed from above, and when it is referred to as "on a cross-section", it means when the cross-section obtained by cutting a target part vertically is viewed from the side.

Hereinafter, a semiconductor package 100 (100A, 100B, 100C, and 100D) of an embodiment and a method for manufacturing the same will be described with reference to the drawings.

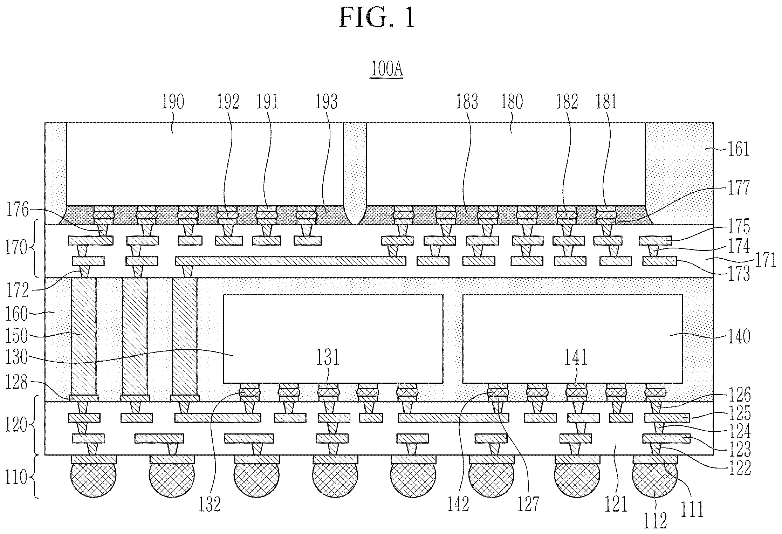

FIG. 1 is a schematic cross-sectional view illustrating a semiconductor package 100A of an embodiment.

Referring to FIG. 1, the semiconductor package 100A may include an external connection structure 110, a front side redistribution structure (first redistribution structure) 120, a first chiplet 130, a second chiplet 140, third connection members 150, a first molding material 160, a back side redistribution structure (second redistribution structure) 170, a communication chip 180, a memory structure 190, and a second molding material 161. In the embodiment, the semiconductor package 100A may be configured as a package-on-package (PoP) structure. In the embodiment, the semiconductor package 100A may be manufactured on the basis of a fan-out wafer-level package (FOWLP) or a fan-out panel-level package (FOPLP) technology.

The external connection structure 110 may be disposed on a lower surface (second surface) of the front side redistribution structure 120. The external connection structure 110 may include conductive pads 111 and external connection members 112. Each of the conductive pads 111 may electrically connect each of first redistribution vias 122 of the front side redistribution structure 120 to each of the external connection members 112. The external connection members 112 may electrically connect the semiconductor package 100A to an external device (not shown in the drawing).

The front side redistribution structure 120 may be disposed on the external connection structure 110. The front side redistribution structure 120 may include a first dielectric 121, first redistribution vias 122, first redistribution lines 123, second redistribution vias 124, second redistribution lines 125, and third redistribution vias 126 which are in the first dielectric 121, and first bonding pads 127 and second bonding pads 128 which are on the first dielectric 121. In other embodiments, the front side redistribution structure 120 may include less or more redistribution lines, redistribution vias, and bonding pads, which may also be included in the scope of the present disclosure.

The first dielectric 121 may protect and insulate the first redistribution vias 122, the first redistribution lines 123, the second redistribution vias 124, the second redistribution lines 125, and the third redistribution vias 126. On an upper surface of the first dielectric 121, the first chiplet 130, the second chiplet 140, the third connection members 150, and the first molding material 160 may be disposed. On a lower surface of the first dielectric 121, the external connection structure 110 may be disposed.

The first redistribution vias 122, the first redistribution lines 123, the second redistribution vias 124, the second redistribution lines 125, and the third redistribution vias 126 may be disposed sequentially from the bottom, and form signal, ground, and power routing paths. Each of the first bonding pads 127 may be disposed between each of the third redistribution vias 126 and each of first connection members 132 or between each of the third redistribution vias 126 and each of second connection members 142. Each of the first bonding pads 127 may electrically connect each of the first connection members 132 to each of the third redistribution vias 126 or electrically connect each of the second connection members 142 to each of the third redistribution vias 126, in the vertical direction perpendicular to a surface (e.g., lower surface) of the front side redistribution structure 120. Each of the second bonding pads 128 may be disposed between each of the third redistribution vias 126 and each of the third connection members 150. Each of the second bonding pads 128 may electrically connect each of the third connection members 150 to each of the third redistribution vias 126 in the vertical direction. The diameter of each of the second bonding pads 128 in a horizontal direction, parallel to the surface of the front side redistribution structure 120, may be larger than the diameter of each of the first bonding pads 127 in the horizontal direction.

The first chiplet (also referred to as the first logic chiplet or the first application processor)130 and the second chiplet (also referred to as the second logic chiplet or the second application processor) 140 may be disposed on an upper surface (also referred to as the first surface which is the opposite surface to a second surface) of the front side redistribution structure 120. The first chiplet 130 may be disposed next to the second chiplet 140. The first chiplet 130 and the second chiplet 140 may be disposed side by side, next to the third connection members 150. In the embodiment, each of the first chiplet 130 and the second chiplet 140 may include an application processors AP.

A "chiplet" is generally defined as a small, modular chip that performs a specific function. Chiplets are designed to be combined with other chiplets that are connected through a standardized high-speed digital interface to form a complete system-on-chip. A system-on-chip (SoC) such as an application processor may be divided into a plurality of chiplets. The plurality of chiplets may be separately manufactured using different process techniques, respectively, and the plurality of chiplets manufactured by performing separate processes may function as one application processor. Each chiplet may be a core independently designed and configured to perform communication with other chiplets through one or more common interface. In an embodiment, each of the plurality of chiplets may include at least one of global logic, an interface, dispatch circuitry, fabric circuitry, logic, input/output (I/O) circuitry, and a memory. In an embodiment, the global logic may include at least one of scheduler logic and power management logic. In an embodiment, the logic may include at least one of central processing units (CPUs), graphic processing units (GPUs), and a codec. In an embodiment, the memory may include an SRAM. In an embodiment, the first chiplet 130 may include at least one of global logic, an interface, dispatch, fabric, and an SRAM. In an embodiment, the second chiplet 140 may include at least one of logic, I/O, and memory.

The first chiplet 130 and the second chiplet 140 may be electrically connected through the front side redistribution structure 120 and route electrical signals to each other. In one or more embodiments, a signal of the first chiplet 130 may be transmitted to the second chiplet 140 through a first signal path passing through a first connection pad 131, a first connection member 132, a first bonding pad 127 connected to the first connection member 132, a third redistribution via 126, a second redistribution line 125, a third redistribution via 126, a first bonding pad 127 connected to a second connection member 142, the second connection member 142, and a second connection pad 141, and a signal of the second chiplet 140 may be transmitted to the first chiplet 130 through a second signal path which may be the reverse of the first signal path.

Although the first chiplet 130 and the second chiplet 140 are shown in the drawing and have been described, the present disclosure is not limited thereto, and more chiplets may be included in the scope of the present disclosure, and the embodiments of the first chiplet 130 and the second chiplet 140 may be applied to more chiplets.

Each of the first connection pads 131 may be disposed between each of wiring lines of the first chiplet 130 and each of the first connection members 132. Each of the first connection pads 131 may electrically connect each of the wiring lines of the first chiplet 130 to each of the first connection members 132. Each of the second connection pads 141 may be disposed between each of wiring lines of the second chiplet 140 and each of the second connection members 142. Each of the second connection pads 141 may electrically connect each of the wiring lines of the second chiplet 140 to each of the second connection members 142. In the embodiment, the first connection pads 131 and the second connection pads 141 may comprise at least one of copper, aluminum, silver, tin, gold, nickel, lead, titanium, or alloys thereof.

Each of the first connection members 132 may be disposed between each of the first connection pads 131 and each of the first bonding pads 127. Each of the first connection members 132 may electrically connect each of the first connection pads 131 to each of the first bonding pads 127. Each of the second connection members 142 may be disposed between each of the second connection pads 141 and each of the first bonding pads 127. Each of the second connection members 142 may electrically connect each of the second connection pads 141 to each of the first bonding pads 127. In an embodiment, the first connection members 132 and the second connection members 142 may include solder bumps. In an embodiment, the first connection members 132 and the second connection members 142 may comprise at least one of tin, silver, lead, nickel, copper, or alloys thereof.

The third connection members 150 may be disposed on the upper surface (first surface) of the front side redistribution structure 120. The third connection members 150 may be disposed next to the first chiplet 130 and the second chiplet 140. Each of the third connection members 150 may be disposed between each of the second bonding pads 128 of the front side redistribution structure 120 and each of fourth redistribution vias 172 of the back side redistribution structure 170. Each of the third connection members 150 may electrically connect each of the fourth redistribution vias 172 of the back side redistribution structure 170 to each of the second bonding pads 128 of the front side redistribution structure 120. The third connection members 150 may be disposed so as to pass through the first molding material 160. The side surfaces of the third connection members 150 may be surrounded by the first molding material 160. The term "surrounded" (or "surrounds," or like terms), as may be used herein, is intended to broadly refer to an element, structure or layer that extends around, envelops, encircles, or encloses another element, structure or layer on all sides, although breaks or gaps may also be present. Thus, for example, a material layer having voids or gaps therein may still "surround" another layer which it encircles. In an embodiment, the third connection members 150 may include a conductive post.

The first molding material 160 may cover the first chiplet 130, the second chiplet 140, and the third connection members 150 on the upper surface (first surface) of the front side redistribution structure 120. The term "cover" (or "covers," or like terms), as may be used herein, is intended to broadly refer to an element, structure or layer that is on or over another element, structure or layer, either directly or with one or more other intervening elements, structures or layers therebetween. The first molding material 160 may protect the first chiplet 130, the second chiplet 140, and the third connection members 150 from the external environment, whereby the semiconductor package 100 may secure the electrical or mechanical stability.

The back side redistribution structure 170 may be disposed on the first chiplet 130, the second chiplet 140, the third connection members 150, and the first molding material 160. The back side redistribution structure 170 may include a second dielectric 171, fourth redistribution vias 172, third redistribution lines 173, fifth redistribution vias 174, fourth redistribution lines 175, and sixth redistribution vias 176 which are in the second dielectric 171, and third bonding pads 177 which are on the second dielectric 171. In other embodiments, the back side redistribution structure 170 may include less or more redistribution lines, redistribution vias, and bonding pads, which may also be included in the scope of the present disclosure.

The second dielectric 171 may protect and insulate the fourth redistribution vias 172, the third redistribution lines 173, the fifth redistribution vias 174, the fourth redistribution lines 175, and the sixth redistribution vias 176. On an upper surface of the second dielectric 171, the communication chip 180, the memory structure 190, a first underfill member 183, a second underfill member 193, and the second molding material 161 may be disposed. On a lower surface of the second dielectric 171, the third connection members 150 and the first molding material 160 may be disposed.

The fourth redistribution vias 172, the third redistribution lines 173, the fifth redistribution vias 174, the fourth redistribution lines 175, and the sixth redistribution vias 176 may be disposed sequentially from the bottom (facing the front side redistribution structure 120), and form signal, ground, and power routing paths. Each of the third bonding pads 177 may be disposed between each of the sixth redistribution vias 176 and each of fourth connection members 182, or between each of the sixth redistribution vias 176 and each of fifth connection members 192. Each of the third bonding pads 177 may electrically connect each of the fourth connection members 182 to each of the sixth redistribution vias 176 or electrically connect each of the fifth connection members 192 to each of the sixth redistribution vias 176, in the vertical direction.

The communication chip 180 may be disposed on the back side redistribution structure 170. The communication chip 180 may be disposed next to (i.e., proximate) the memory structure 190 in the horizontal direction. The communication chip 180 may be electrically connected to the first chiplet 130 and the second chiplet 140 through the front side redistribution structure 120, the third connection members 150, and the back side redistribution structure 170. The communication chip 180 may enable wireless communication for transferring data to the first chiplet 130 and the second chiplet 140 and from the first chiplet 130 and the second chiplet 140. The communication chip 180 may communicate with various types of external devices according to various types of communication methods and/or protocols. In one or more embodiments, the communication chip 180 may be configured to perform communication according to various communication standards such as Wi-Fi, Bluetooth, near-field communication (NFC), IEEE, ZigBee, 3rd generation (3G), 3rd generation partnership project (3GPP), long term evolution (LTE), and 5th generation (5G), although embodiments are not limited thereto.

Third connection pads 181 may be disposed on a lower surface of the communication chip 180. Each of the third connection pads 181 may be disposed between each of wiring lines of the communication chip 180 and each of the fourth connection members 182. Each of the third connection pads 181 may electrically connect each of the wiring lines of the communication chip 180 to each of the fourth connection members 182. In an embodiment, the third connection pads 181 may comprise at least one of copper, aluminum, silver, tin, gold, nickel, lead, titanium, or alloys thereof.

Each of the fourth connection members 182 may be disposed between each of the third connection pads 181 and each of the third bonding pads 177. Each of the fourth connection members 182 may electrically connect each of the third connection pads 181 to each of the third bonding pads 177. In an embodiment, each of the fourth connection members 182 may include a solder bump. In an embodiment, the fourth connection members 182 may comprise at least one of tin, silver, lead, nickel, copper, or alloys thereof.

The first underfill member 183 may be disposed between the back side redistribution structure 170 and the communication chip 180. The first underfill member 183 may surround and protect the third bonding pads 177, the third connection pads 181, and the fourth connection members 182. In an embodiment, the first underfill member 183 may include a non-conductive film (NCF). In an embodiment, the first underfill member 183 may include a molded underfill (MUF).

The memory structure 190 may be disposed on the back side redistribution structure 170. The memory structure 190 may be disposed next to the communication chip 180 in the horizontal (i.e., lateral) direction. The memory structure 190 may be electrically connected to the first chiplet 130 and the second chiplet 140 through the front side redistribution structure 120, the third connection members 150, and the back side redistribution structure 170. In an embodiment, the memory structure 190 may include a single chip such as a DRAM or a multi-chip such as a high bandwidth memory (HBM). The memory structure 190 may include memory banks.

Fourth connection pads 191 may be disposed on a lower surface of the memory structure 190. Each of the fourth connection pads 191 may be disposed between each of wiring lines of the memory structure 190 and each of the fifth connection members 192. Each of the fourth connection pads 191 may electrically connect each of the wiring lines of the memory structure 190 to each of the fifth connection members 192. In an embodiment, the fourth connection pads 191 may comprise at least one of copper, aluminum, silver, tin, gold, nickel, lead, titanium, or alloys thereof.

Each of the fifth connection members 192 may be disposed between each of the fourth connection pads 191 and each of the third bonding pads 177. Each of the fifth connection members 192 may electrically connect each of the fourth connection pads 191 to each of the third bonding pads 177. In an embodiment, each of the fifth connection members 192 may include a solder bump. In an embodiment, the fifth connection members 192 may comprise at least one of tin, silver, lead, nickel, copper, or alloys thereof.

The second underfill member 193 may be disposed between the back side redistribution structure 170 and the memory structure 190. The second underfill member 193 may surround and protect the third bonding pads 177, the fourth connection pads 191, and the fifth connection members 192. In an embodiment, the second underfill member 193 may include a non-conductive film (NCF). In an embodiment, the second underfill member 193 may include an MUF.

The second molding material 161 may cover the communication chip 180 and the memory structure 190 on the back side redistribution structure 170. The upper surface of the communication chip 180 and the upper surface of the memory structure 190 may be exposed from the second molding material 161, and have the same level as the level of the upper surface of the second molding material 161; that is, the upper surface of the communication chip 180 and the upper surface of the memory structure 190 may be coplanar with the upper surface of the second molding material 161 in the vertical direction. The term "exposed" (or "exposes," or like terms) may be used herein to describe relationships between elements and/or with reference to intermediate processes in fabricating a semiconductor device, but may not require exposure of a particular element in the completed device. Likewise, the term "not exposed" may be used to described relationships between elements and/or with reference to intermediate processes in fabricating a semiconductor device, but may not require a particular element to be unexposed in the completed device. The second molding material 161 may protect the communication chip 180 and the memory structure 190 from the external environment, thereby securing the electrical or mechanical stability of the semiconductor package 100.

According to the present disclosure, in the semiconductor package 100A including the application processor divided into the plurality of chiplets (the first chiplet 130 and the second chiplet 140), the communication chip 180 may be disposed on the plurality of chiplets. Accordingly, it is not necessary to separately form a communication chip package inside an electronic product, and it is possible to reduce the space inside an electronic product occupied by the communication chip package.

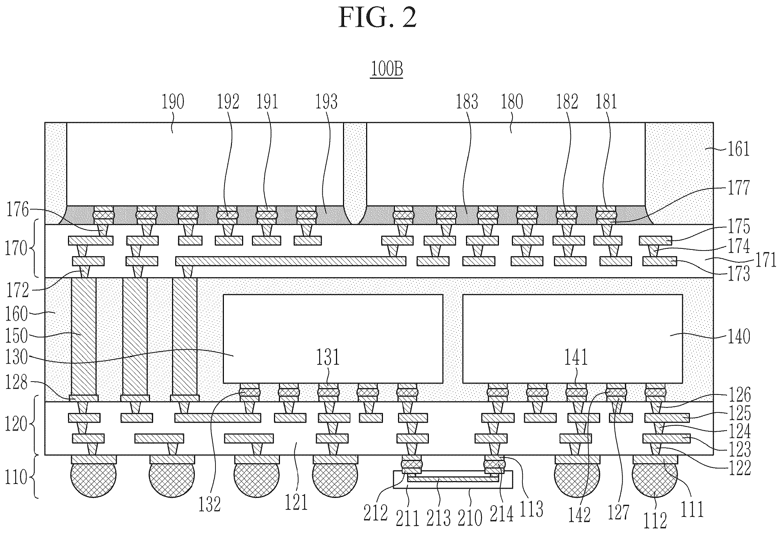

FIG. 2 is a schematic cross-sectional view illustrating a semiconductor package 100B, according to an embodiment of the present disclosure.

Referring to FIG. 2, the semiconductor package 100B may include a bridge die 210. The bridge die 210 may be disposed on the second (i.e., lower) surface of the front side redistribution structure 120. The bridge die 210 may be disposed next to the external connection members 112 in the horizontal direction (e.g., between adjacent external connection members 112). The bridge die 210 may electrically connect the first chiplet 130 to the second chiplet 140 through the front side redistribution structure 120. The first chiplet 130 and the second chiplet 140 may be electrically connected to each other through the front side redistribution structure 120 and through the bridge die 210, and route electrical signals to each other. In an embodiment, the bridge die 210 may include a silicon bridge die.

The bridge die 210 may include a bridge die base 211, connection pads 212, and signal lines 213. The bridge die base 211 may be a die formed from a wafer. In an embodiment, the bridge die base 211 may comprise silicon or other semiconductor materials. The bridge die base 211 may include the connection pads 212 and the signal lines 213 therein. Each of the connection pads 212 may be disposed between each of the signal lines 213 and each of sixth connection members 214. Each of the connection pads 212 may electrically connect each of the signal lines 213 to each of the sixth connection members 214. Each of the signal lines 213 may be connected to the connection pads 212, and transfer signals between the first chiplet 130 and the second chiplet 140. In an embodiment, the connection pads 212 and the signal lines 213 may comprise at least one of copper, aluminum, silver, tin, gold, nickel, lead, titanium, or alloys thereof.

The bridge die 210 may be connected to the front side redistribution structure 120 through fourth bonding pads 113 and the sixth connection members 214. The fourth bonding pads 113 may be disposed on the lower surface (second surface) of the front side redistribution structure 120. Each of the fourth bonding pads 113 may be disposed between each of the sixth connection members 214 and each of the first redistribution vias 122. Each of the fourth bonding pads 113 may electrically connect each of the first redistribution vias 122 to each of the sixth connection members 214. In an embodiment, the fourth bonding pads 113 may comprise at least one of copper, aluminum, silver, tin, gold, nickel, lead, titanium, or alloys thereof.

Each of the sixth connection members 214 may be disposed between each of the connection pads 212 and each of the fourth bonding pads 113. Each of the sixth connection members 214 may electrically connect each of the fourth bonding pads 113 to each of the connection pads 212. In an embodiment, the sixth connection members 214 may include a solder bump. In an embodiment, the sixth connection members 214 may comprise at least one of tin, silver, lead, nickel, copper, or alloys thereof.

In respect to the contents about the semiconductor package 100B of the embodiment of FIG. 2 other than the above-described contents, the contents described with respect to the semiconductor package 100A of FIG. 1 may be applied.

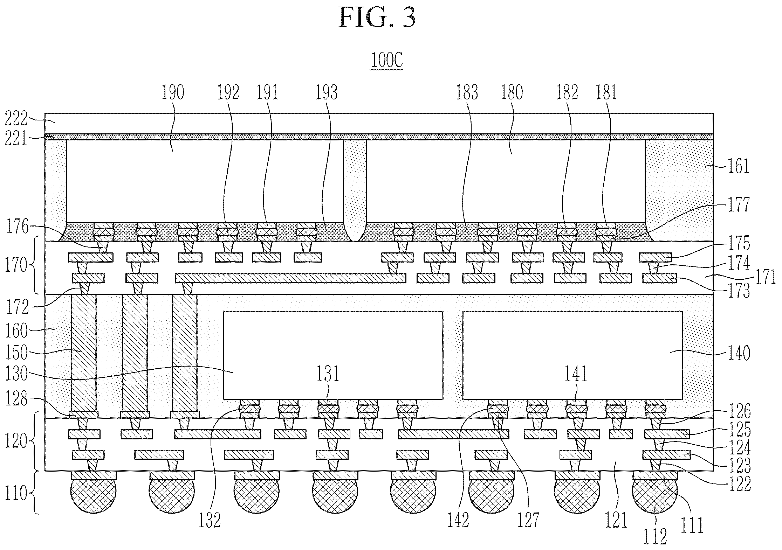

FIG. 3 is a schematic cross-sectional view illustrating a semiconductor package 100C, according to an embodiment of the present disclosure.

Referring to FIG. 3, the semiconductor package 100C may include an adhesive member 221 and a heat dissipation structure 222.

The adhesive member 221 may be disposed between the communication chip 180 and the heat dissipation structure 222, between the memory structure 190 and the heat dissipation structure 222, and between the second molding material 161 and the heat dissipation structure 222. The adhesive member 221 may attach the heat dissipation structure 222 to the communication chip 180, the memory structure 190, and the second molding material 161. In an embodiment, the adhesive member 221 may include a thermal interface material (TIM). The thermal interface material (TIM) may be inserted between the communication chip 180 and the memory structure 190 which generate heat and the heat dissipation structure 222 which dissipates heat, to improve thermal coupling between the communication chip 180 and the heat dissipation structure 222 and between the memory structure 190 and the heat dissipation structure 222. The thermal interface material (TIM) serves to fill air gaps between the contact surfaces of the communication chip 180 and the heat dissipation structure 222 and between the contact surfaces of the memory structure 190 and the heat dissipation structure 222, thereby reducing thermal contact resistance.

The heat dissipation structure 222 may be disposed on the second molding material 161, the communication chip 180, and the memory structure 190. The heat dissipation structure 222 may be attached to the upper surfaces of the second molding material 161, the communication chip 180, and the memory structure 190 by the adhesive member 221. The heat dissipation structure 222 may be thermally connected to the communication chip 180 and the memory structure 190. In an embodiment, the heat dissipation structure 222 may include a heat slug, a heat sink, or a heat spreader. In an embodiment, the heat dissipation structure 222 may comprise a conductive material having a high thermal conductivity, such as, for example, copper or aluminum.

In respect to the contents about the semiconductor package 100C of the embodiment of FIG. 3 other than the above-described contents, the contents described with respect to the semiconductor package 100A of FIG. 1 may be applied.

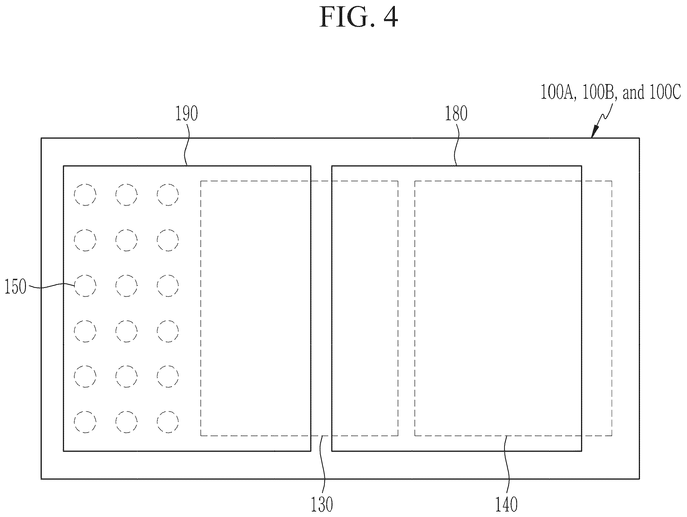

FIG. 4 is a schematic plan view illustrating the upper surface of each of the semiconductor packages 100A, 100B, and 100C of the embodiments of FIGS. 1, 2, and 3, respectively. In FIG. 4, the communication chip 180 and the memory structure 190 are shown by solid lines (indicative of the upper surfaces of the communication chip 180 and the memory structure 190 exposed through the second molding material 161 in FIGS. 1, 2 and 3), and the first chiplet 130, the second chiplet 140, and the third connection members 150 are shown by dotted lines.

Referring to FIG. 4, the first chiplet 130 and the second chiplet 140 may be disposed side by side in the horizontal direction. The third connection members 150 may be disposed next to the first chiplet 130 and next to the second chiplet 140. The communication chip 180 and the memory structure 190 may be disposed side by side in the horizontal direction.

The footprint of the communication chip 180 may overlap the footprint of the first chiplet 130 and the footprint of the second chiplet 140 in the vertical direction. As used herein, "an element A overlapping an element B in a direction X" (or similar language) means that there is at least one line that extends in the direction X and intersects both the elements A and B. Heat which is generated by the first chiplet 130 and the second chiplet 140 may form a hot spot between the first chiplet 130 and the second chiplet 140, and the communication chip 180 may be disposed on the hot spot between the first chiplet 130 and the second chiplet 140. Accordingly, heat which is generated by the first chiplet 130 and the second chiplet 140 may be efficiently dissipated to the outside through the communication chip 180 manufactured on the basis of a silicon material. The footprint of the communication chip 180 may not overlap the footprints of the third connection members 150. The footprint of the memory structure 190 may overlap the footprints of the third connection members 150.

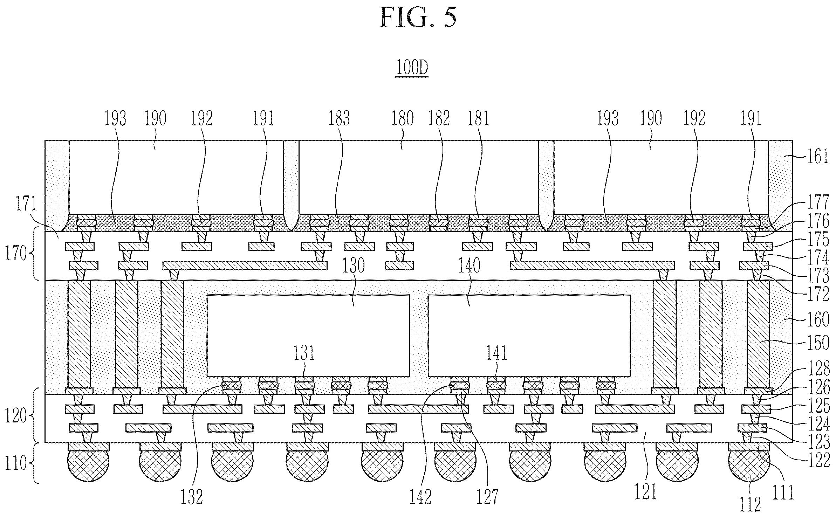

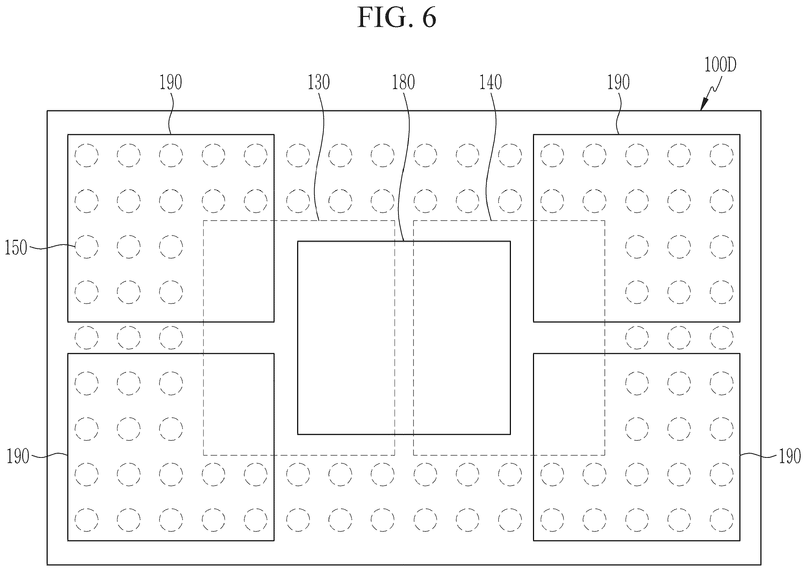

FIG. 5 is a schematic cross-sectional view illustrating a semiconductor package 100D, according to an embodiment. FIG. 6 is a schematic plan view illustrating an upper surface of the semiconductor package 100D of the embodiment of FIG. 5. In FIG. 6, a communication chip 180 and a plurality of memory structures 190 are shown by solid lines, and a first chiplet 130, a second chiplet 140, and third connection members 150 are shown by dotted lines.

Referring to FIGS. 5 and 6, the semiconductor package 100D may have a symmetrical structure in the horizontal direction. The semiconductor package 100D may include the third connection members 150 which are disposed around the first chiplet 130 and the second chiplet 140. The semiconductor package 100D may include a plurality of memory structures 190 which are disposed around the communication chip 180. Each of the first chiplet 130 and the second chiplet 140 may be electrically connected to each of the memory structures 190 through the third connection members 150 adjacent thereto.

The footprint of the communication chip 180 may overlap the footprint of the first chiplet 130 and the footprint of the second chiplet 140. Heat which is generated by the first chiplet 130 and the second chiplet 140 may form a hot spot between the first chiplet 130 and the second chiplet 140, and the communication chip 180 may be disposed on the hot spot between the first chiplet 130 and the second chiplet 140. Accordingly, heat which is generated by the first chiplet 130 and the second chiplet 140 may be efficiently dissipated to the outside through the communication chip 180 manufactured on the basis of a silicon material. The footprint of the communication chip 180 may not overlap the footprints of the third connection members 150. The footprint of each of the memory structures 190 may overlap the footprints of the third connection members 150.

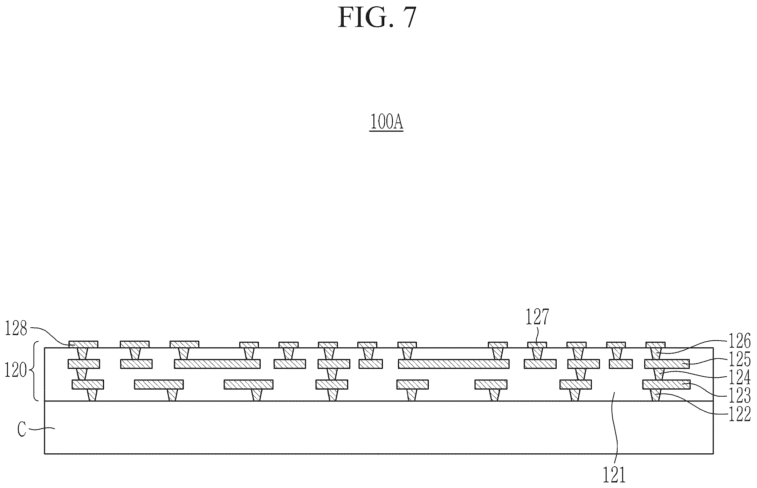

FIGS. 7 to 16 are schematic cross-sectional views illustrating intermediate processes in an example method for manufacturing the semiconductor package 100A of the embodiment of FIG. 1, according to one or more embodiments of the present disclosure. The method for manufacturing the semiconductor package 100A of the embodiment of FIG. 1 may be applied to methods for manufacturing the semiconductor packages 100B, 100C, and 100D of the embodiments of FIGS. 2, 3, and 5, respectively.

FIG. 7 is a schematic cross-sectional view illustrating a step of forming the front side redistribution structure 120 on a carrier C.

Referring to FIG. 7, the front side redistribution structure 120 may be formed on the carrier C. First, the carrier C may be provided. In an embodiment, the carrier C may comprise a silicon-based material such as glass or silicon oxide, other materials such as aluminum oxide or an organic material, or any combination of these materials.

Next, a first dielectric 121 may be formed on the carrier C. In an embodiment, the first dielectric 121 may comprise a photoimageable dielectric (PID) that is used in a redistribution process. As an embodiment, the photoimageable dielectric (PID) may comprise a polyimide-based photosensitive polymer, a novolac-based photosensitive polymer, polybenzoxazole, a silicon-based polymer, an acrylate-based polymer, or an epoxy-based polymer. In an embodiment, the first dielectric 121 may be formed by performing a spin coating process.

After the first dielectric 121 is formed, via holes may be formed by selectively etching the first dielectric 121, and the via holes may be filled with a conductive material, whereby the first redistribution vias 122 may be formed. The term "filled" (or "fills," or like terms) is intended to refer to either completely filling a defined space (e.g., the via holes) or partially filling the defined space; that is, the defined space need not be entirely filled but may, for example, be partially filled or have voids or other spaces throughout. After the first redistribution vias 122 are formed, on the first redistribution vias 122 and the first dielectric 121, a first dielectric 121 may be additionally formed, and openings may be formed by selectively etching the first dielectric 121 additionally formed, and the openings may be filled with a conductive material, whereby the first redistribution lines 123 may be formed. After the first redistribution lines 123 are formed, on the first redistribution lines 123 and the first dielectric 121, a first dielectric 121 may be additionally formed, and via holes may be formed by selectively etching the first dielectric 121 additionally formed, and the via holes may be filled with a conductive material, whereby the second redistribution vias 124 may be formed. After the second redistribution vias 124 are formed, on the second redistribution vias 124 and the first dielectric 121, a first dielectric 121 may be additionally formed, and openings may be formed by selectively etching the first dielectric 121 additionally formed, and the openings may be filled with a conductive material, whereby the second redistribution lines 125 may be formed. After the second redistribution lines 125 are formed, on the second redistribution lines 125 and the first dielectric 121, a first dielectric 121 may be additionally formed, and via holes may be formed by selectively etching the first dielectric 121 additionally formed, and the via holes may be filled with a conductive material, whereby the third redistribution vias 126 may be formed. After the third redistribution vias 126 may be formed, a photoresist pattern including via holes may be formed by additionally depositing a photoresist on the third redistribution vias 126 and the first dielectric 121 and selectively exposing and developing the photoresist, and the via holes may be filled with a conductive material, whereby the first bonding pads 127 and the second bonding pads 128 may be formed.

In an embodiment, each of the first redistribution vias 122, the first redistribution lines 123, the second redistribution vias 124, the second redistribution lines 125, the third redistribution vias 126, the first bonding pads 127, and the second bonding pads 128 may comprise at least one of copper, aluminum, tungsten, nickel, gold, tin, titanium, or alloys thereof. In an embodiment, each of the first redistribution vias 122, the first redistribution lines 123, the second redistribution vias 124, the second redistribution lines 125, the third redistribution vias 126, the first bonding pads 127, and the second bonding pads 128 may be formed by performing a sputtering process. In an embodiment, each of the first redistribution vias 122, the first redistribution lines 123, the second redistribution vias 124, the second redistribution lines 125, the third redistribution vias 126, the first bonding pads 127, and the second bonding pads 128 may be formed by forming a seed metal layer and then performing an electroplating process.

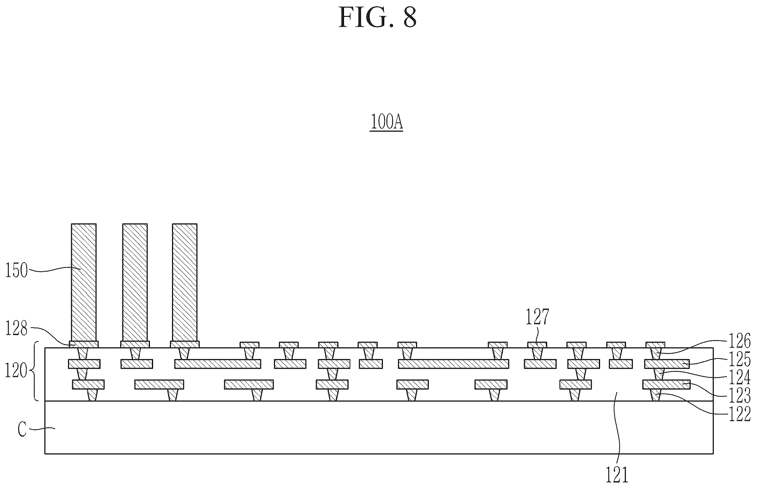

FIG. 8 is a schematic cross-sectional view illustrating a step of forming the third connection members 150 on the front side redistribution structure 120.

Referring to FIG. 8, the third connection members 150 may be formed on the second bonding pads 128 of the front side redistribution structure 120. A photoresist pattern including holes may be formed by depositing a photoresist and selectively exposing and developing the photoresist, and the holes may be filled with a conductive material, whereby the third connection members 150 may be formed. In an embodiment, the third connection members 150 may be formed by performing a sputtering process. In an embodiment, the third connection members 150 may be formed by forming a seed metal layer and then performing an electroplating process. In an embodiment, the third connection members 150 may comprise at least one of copper, aluminum, tungsten, nickel, gold, silver, chromium, antimony, tin, titanium, or alloys thereof.

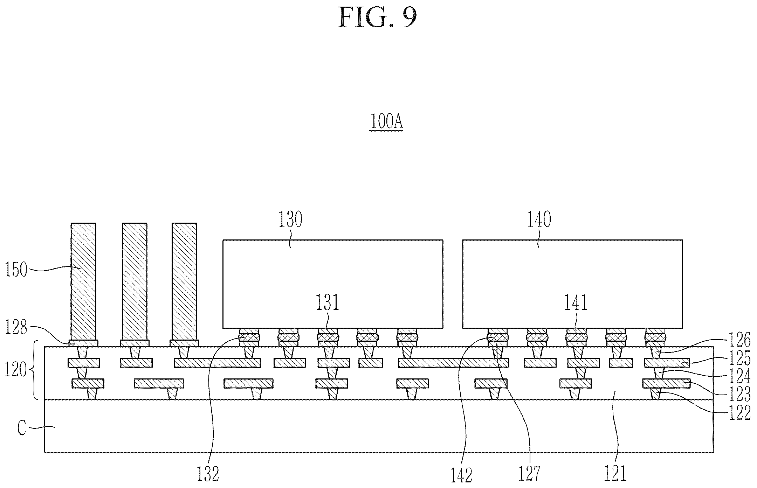

FIG. 9 is a schematic cross-sectional view illustrating a step of mounting the first chiplet 130 and the second chiplet 140 on the front side redistribution structure 120.

Referring to FIG. 9, the first chiplet 130 and the second chiplet 140 may be mounted on the first bonding pads 127 of the front side redistribution structure 120. In an embodiment, the first chiplet 130 and the second chiplet 140 may be bonded to the upper surfaces of the first bonding pads 127 of the front side redistribution structure 120 by performing a flip-chip bonding process, although embodiments are not limited thereto. The first chiplet 130 may be bonded to the first bonding pads 127 of the front side redistribution structure 120 by the first connection members 132, and the second chiplet 140 may be bonded to the first bonding pads 127 of the front side redistribution structure 120 by the second connection members 142, whereby the first chiplet 130 and the front side redistribution structure 120 may be electrically connected (via the first connection pads 131 of the first chiplet 130) and the second chiplet 140 and the front side redistribution structure 120 may be electrically connected (via the second connection pads 141 of the second chiplet 140).

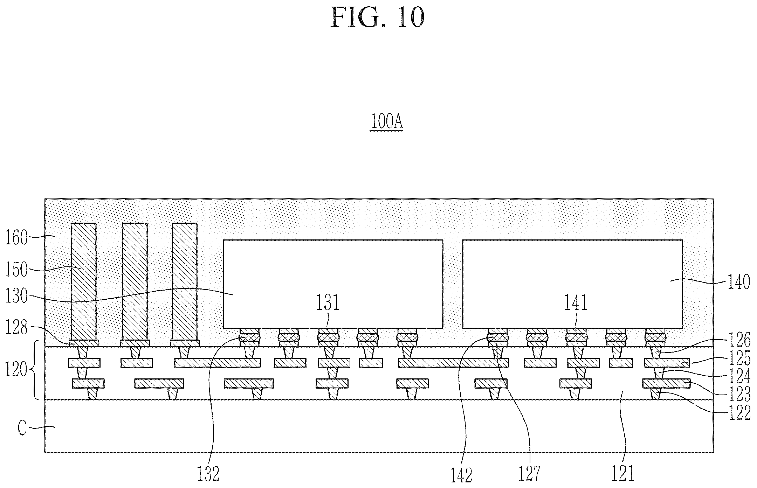

FIG. 10 is a schematic cross-sectional view illustrating a step of encapsulating the first chiplet 130, the second chiplet 140, and the third connection members 150 on the front side redistribution structure 120.

Referring to FIG. 10, the first chiplet 130, the second chiplet 140, and the third connection members 150 may be covered on the front side redistribution structure 120 by the first molding material 160. As an embodiment, the process of performing encapsulating by the first molding material 160 may include a compression molding or transfer molding process. In an embodiment, the first molding material 160 may comprise an epoxy molding compound (EMC).

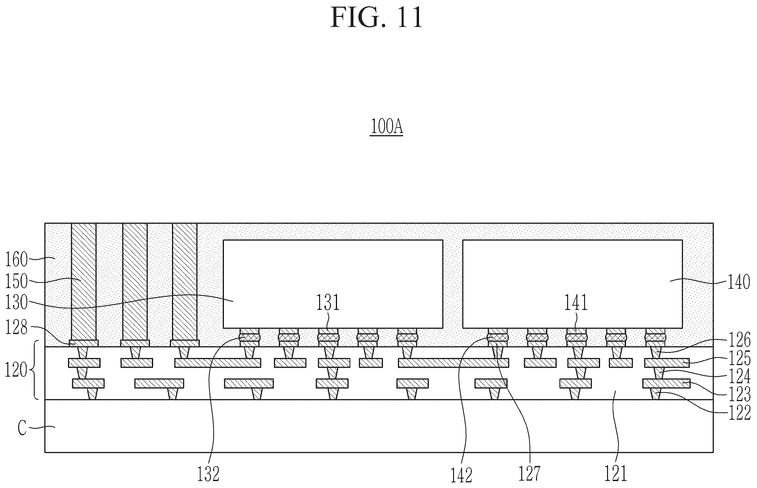

FIG. 11 is a schematic cross-sectional view illustrating a step of performing a chemical mechanical planarization (CMP) process on the first molding material 160.

Referring to FIG. 11, in order to level the upper surface of the first molding material 160, the upper surface of the first molding material 160 may be planarized by performing a chemical mechanical planarization (CMP) process. After the chemical mechanical planarization (CMP) process is performed, the upper surfaces of the third connection members 150 may be exposed.

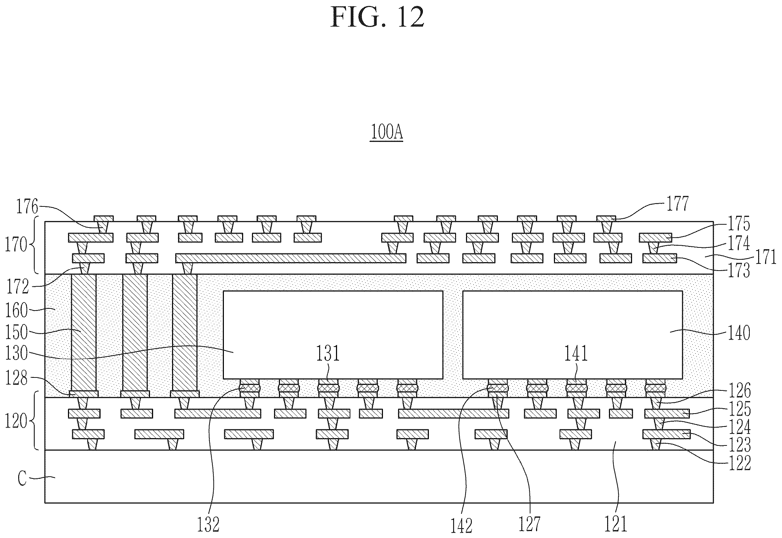

FIG. 12 is a schematic cross-sectional view illustrating a step of forming the back side redistribution structure 170 on the third connection members 150 and the first molding material 160.

Referring to FIG. 12, a second dielectric 171 may be formed on the third connection members 150 and the first molding material 160. In an embodiment, the second dielectric 171 may comprise a photoimageable dielectric (PID) that is used in a redistribution process. As an embodiment, the photoimageable dielectric (PID) may comprise a polyimide-based photosensitive polymer, a novolac-based photosensitive polymer, polybenzoxazole, a silicon-based polymer, an acrylate-based polymer, or an epoxy-based polymer. In an embodiment, the second dielectric 171 may be formed by performing a spin coating process.

After the second dielectric 171 is formed, via holes may be formed by selectively etching the second dielectric 171, and the via holes may be filled with a conductive material, whereby the fourth redistribution vias 172 may be formed. After the fourth redistribution vias 172 may be formed, on the fourth redistribution vias 172 and the second dielectric 171, a second dielectric 171 may be additionally formed, and openings may be formed by selectively etching the second dielectric 171 additionally formed, and the openings may be filled with a conductive material, whereby the third redistribution lines 173 may be formed. After the third redistribution lines 173 are formed, on the third redistribution lines 173 and the second dielectric 171, a second dielectric 171 may be additionally formed, and via holes may be formed by selectively etching the second dielectric 171 additionally formed, and the via holes may be filled with a conductive material, whereby the fifth redistribution vias 174 may be formed. After the fifth redistribution vias 174 are formed, on the fifth redistribution vias 174 and the second dielectric 171, a second dielectric 171 may be additionally formed, and openings may be formed by selectively etching the second dielectric 171 additionally formed, and the openings may be filled with a conductive material, whereby the fourth redistribution lines 175 may be formed. After the fourth redistribution lines 175 are formed, on the fourth redistribution lines 175 and the second dielectric 171, a second dielectric 171 may be additionally formed, and via holes may be formed by selectively etching the second dielectric 171 additionally formed, and the via holes may be filled with a conductive material, whereby the sixth redistribution vias 176 may be formed. After the sixth redistribution vias 176 are formed, on the sixth redistribution vias 176 and the second dielectric 171, a photoresist pattern including via holes may be formed by additionally depositing a photoresist on the sixth redistribution vias 176 and the second dielectric 171 and selectively exposing and developing the photoresist, and the via holes may be filled with a conductive material, whereby the third bonding pads 177 may be formed.

In an embodiment, each of the fourth redistribution vias 172, the third redistribution lines 173, the fifth redistribution vias 174, the fourth redistribution lines 175, the sixth redistribution vias 176, and the third bonding pads 177 may comprise at least one of copper, aluminum, tungsten, nickel, gold, tin, titanium, or alloys thereof. In an embodiment, each of the fourth redistribution vias 172, the third redistribution lines 173, the fifth redistribution vias 174, the fourth redistribution lines 175, the sixth redistribution vias 176, and the third bonding pads 177 may be formed by performing a sputtering process. In an embodiment, each of the fourth redistribution vias 172, the third redistribution lines 173, the fifth redistribution vias 174, the fourth redistribution lines 175, the sixth redistribution vias 176, and the third bonding pads 177 may be formed by forming a seed metal layer and then performing an electroplating process.

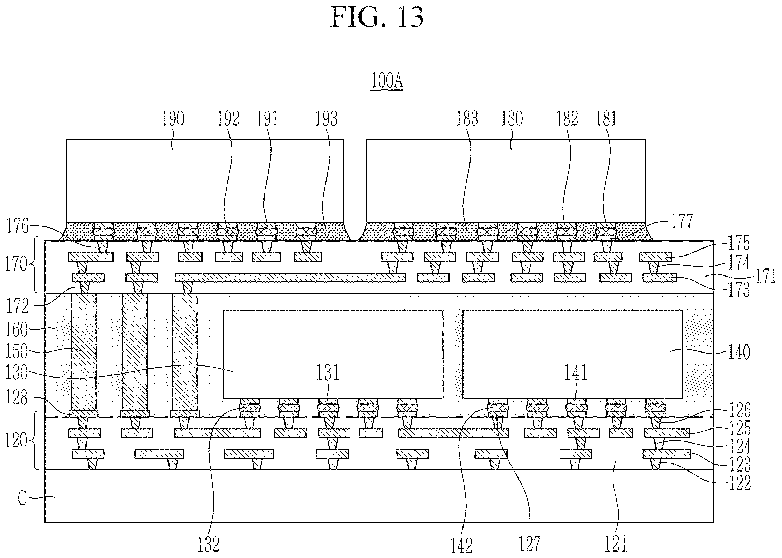

FIG. 13 is a schematic cross-sectional view illustrating a step of attaching the communication chip 180 and the memory structure 190 on the back side redistribution structure 170.

Referring to FIG. 13, the communication chip 180 and the memory structure 190 may be attached on the back side redistribution structure 170. In one or more embodiments, the communication chip 180 and the memory structure 190 may be bonded to the upper surfaces of the third bonding pads 177 of the back side redistribution structure 170 by performing a thermal compression process on the communication chip 180 with the first underfill member 183 attached thereon and the memory structure 190 with the second underfill member 193 attached thereon. The communication chip 180 may be bonded to the third bonding pads 177 of the back side redistribution structure 170 by the fourth connection members 182, and the memory structure 190 may be bonded to the third bonding pads 177 of the back side redistribution structure 170 by the fifth connection members 192, whereby the communication chip 180 and the back side redistribution structure 170 may be electrically connected (via the third connection pads 181 of the communication chip 180), and the memory structure 190 and the back side redistribution structure 170 may be electrically connected (via the fourth connection pads 191 of the memory structure 190).

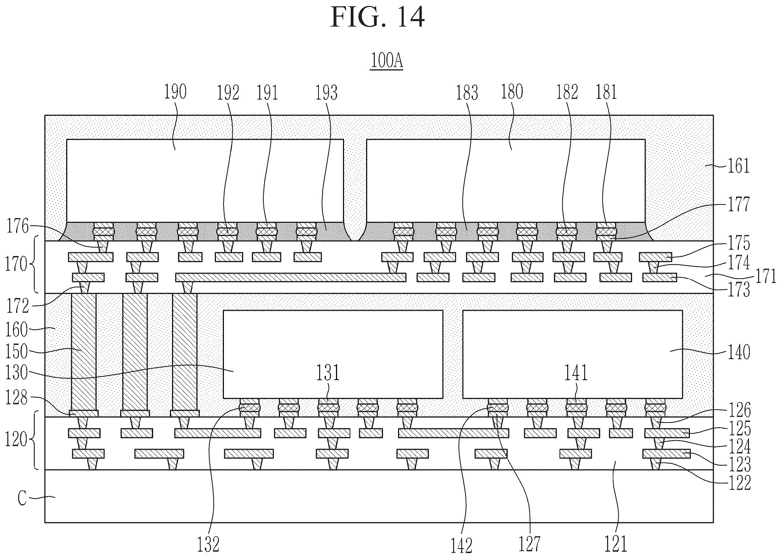

FIG. 14 is a schematic cross-sectional view illustrating a step of encapsulating the communication chip 180 and the memory structure 190 on the back side redistribution structure 170.

Referring to FIG. 14, the communication chip 180 and the memory structure 190 may be covered on the back side redistribution structure 170 by the second molding material 161. As an embodiment, the process of performing encapsulating by the second molding material 161 may include a compression molding or transfer molding process. In an embodiment, the second molding material 161 may comprise an epoxy molding compound (EMC).

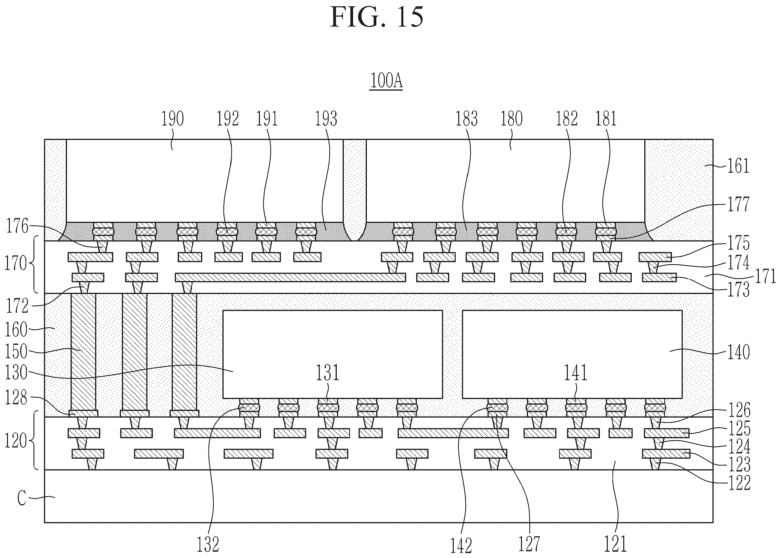

FIG. 15 is a cross-sectional view illustrating a step of performing a chemical mechanical planarization (CMP) process on the second molding material 161.

Referring to FIG. 15, in order to level the upper surface of the second molding material 161, the upper surface of the second molding material 161 may be planarized by performing a chemical mechanical planarization (CMP) process. After the chemical mechanical planarization (CMP) process is performed, the upper surfaces of the communication chip 180 and the memory structure 190 may be exposed.

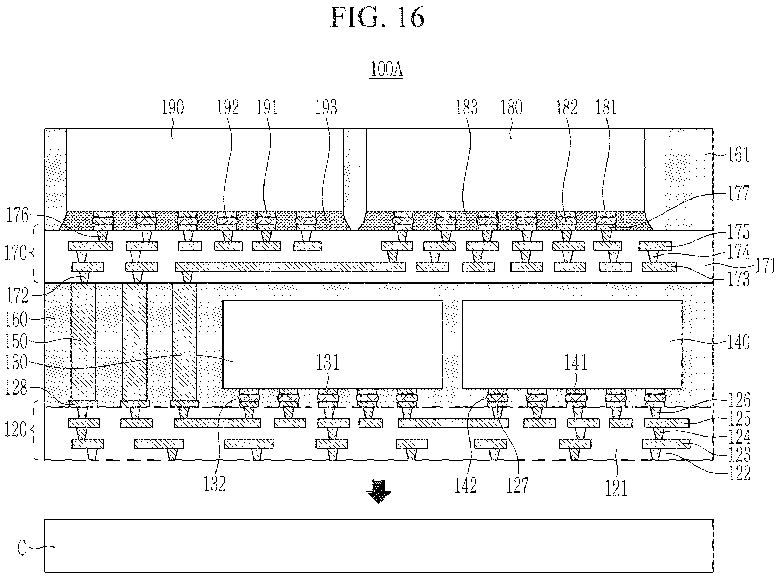

FIG. 16 is a schematic cross-sectional view illustrating a step of removing the carrier C from the front side redistribution structure 120.

Referring to FIG. 16, the carrier C may be removed from the lower surface of the front side redistribution structure 120. Thereafter, as shown in FIG. 1, the external connection structure 110 may be formed on the lower surface of the front side redistribution structure 120. Below the first redistribution vias 122 of the front side redistribution structure 120, the conductive pads 111 may be formed. In an embodiment, a conductive pad 111 may comprise at least one of copper, nickel, zinc, gold, silver, platinum, palladium, chromium, titanium, or alloys thereof. In an embodiment, a conductive pad 111 may be formed by a sputtering process or by forming a seed metal layer and then performing an electroplating process. Thereafter, below the conductive pads 111, the external connection member 112 may be formed. In an embodiment, the external connection member 112 may comprise at least one of tin, silver, lead, nickel, copper, or alloys thereof.

While this invention has been described in connection with what is presently considered to be practical embodiments, it is to be understood that the invention is not limited to the disclosed embodiments. On the contrary, it is intended to cover various modifications and equivalent arrangements included within the scope of the appended claims.

## Claims

1. A semiconductor package, comprising:
a first redistribution structure (120);
a first chiplet (130) on a first surface of the first redistribution structure (120);
a second chiplet (140) on the first surface of the first redistribution structure (120) and proximate the first chiplet (130);
a second redistribution structure (170) on the first chiplet (130) and on the second chiplet (140); and
a communication chip (180) on the second redistribution structure (170).

2. The semiconductor package of claim 1, wherein:
a footprint of the communication chip (180) at least partially overlaps a footprint of the first chiplet (130) and a footprint of the second chiplet (140) in a first direction perpendicular to a surface of the first redistribution structure (120).

3. The semiconductor package of claim 1 or 2, wherein:
the first chiplet (130) and the second chiplet (140) are electrically connected to each other through the first redistribution structure (120).

4. The semiconductor package of any one of claims 1 to 3, wherein:
the first chiplet (130) includes at least one of global logic, an interface, dispatch circuitry, or fabric circuitry.

5. The semiconductor package of any one of claims 1 to 4, wherein:
the second chiplet (140) includes at least one of logic, input/output, I/O, circuitry, and a memory.

6. The semiconductor package of any one of claims 1 to 5, further comprising:
a bridge die (210) on a second surface of the first redistribution structure (120), the second surface opposite to the first surface in a first direction perpendicular to a surface of the first redistribution structure (120).

7. The semiconductor package of claim 6, wherein:
the first chiplet (130) and the second chiplet (140) are electrically connected to each other through the first redistribution structure (120) and the bridge die (210).

8. The semiconductor package of any one of claims 1 to 7, further comprising:
a plurality of memory structures (190) on the second redistribution structure (170) and around the communication chip (180).

9. The semiconductor package of claim 8, further comprising:
a plurality of connection members (150) on the first surface of the first redistribution structure (120), and around the first chiplet (130) and the second chiplet (140).

10. The semiconductor package of claim 9, wherein:
each of the plurality of connection members (150) includes a conductive post.

11. The semiconductor package of claim 9 or 10, wherein:
footprints of the plurality of memory structures (190) at least partially overlap footprints of the plurality of connection members (150) in a first direction perpendicular to a surface of the first redistribution structure (120).

12. The semiconductor package of any one of claims 8 to 11, wherein:
at least one memory structure of the plurality of memory structures (190) includes a high bandwidth memory, HBM.

13. The semiconductor package of any one of claims 8 to 12, wherein:
at least one memory structure of the plurality of memory structures (190) includes a DRAM chip.

14. The semiconductor package of any one of claims 8 to 13, further comprising:
a heat dissipation structure (222) on the plurality of memory structures (190), and on the communication chip (180).

15. The semiconductor package of any one of claims 1 to 14, wherein:
each of the first chiplet (130) and the second chiplet (140) includes an application processor, AP.
